Europäisches Patentamt

European Patent Office

Office européen des brevets

(11) Veröffentlichungsnummer: **0 328 039**
**A2**

(12) **EUROPÄISCHE PATENTANMELDUNG**

(21) Anmeldenummer: 89102067.9

(51) Int. Cl.⁴: **B41F 27/00**

(22) Anmeldetag: 07.02.89

(30) Priorität: 09.02.88 DE 8801605 U

(43) Veröffentlichungstag der Anmeldung:
16.08.89 Patentblatt 89/33

(84) Benannte Vertragsstaaten:
DE FR GB IT SE

(71) Anmelder: **FIRMA WILHELM BARENSCHEE**
**Bleckeder Landstrasse 37**
**D-2120 Lüneburg(DE)**

(72) Erfinder: **Miethe, Manfred**
**Eichenhain 41**
**D-2121 Reppenstedt(DE)**

(74) Vertreter: **Glaeser, Joachim, Dipl.-Ing.**
**Patentanwalt Königstrasse 28**
**D-2000 Hamburg 50(DE)**

(54) **Vorrichtung zum Entfernen von Zwischenlagenpapier.**

(57) An einer Stanzeinrichtung bei der Herstellung registerhaltiger Offsetplatten angeordnete Vorrichtung zum Entfernen des obersten Zwischenlagenpapiers der aufeinander gestapelten Offsetplatten. Die Vorrichtung weist mindestens einen in den Stapelbereich für die Stanzeinrichtung bringbaren Arm (10) auf, von dessen frei vorstehendem Ende zwei Greifteile (13, 14) im wesentlichen senkrecht nach unten vorstehen, von denen wenigstens einer mit Anpreßteilen (15, 16) am unteren Ende versehen ist. Die Anpreßteile (15, 16) können auf den Stapel der Offsetplatten gebracht werden, mindestens der eine der beiden Greifteile tritt mit dem Zwischenlagenpapier in direkten Berührungseingriff und schiebt das Zwischenlagenpapier in den Zwischenraum zwischen den Greifteilen, so daß mit dem Herausfahren der Greifteile das Zwischenlagenpapier entfernt wird.

Fig. 4

## Vorrichtung zum Entfernen von Zwischenlagenpapier

Die Erfindung bezieht sich auf eine an einer Stanzeinrichtung bei der Herstellung registerhaltiger Offsetplatten angeordnete Vorrichtung zum Entfernen des obersten Zwischenlagenpapiers von aufeinander gestapelten Offsetplatten.

Das zum Schutz der empfindlichen Plattenoberfläche von Offsetplatten jeweils zwischen zwei Offsetplatten eingelegte Zwischenlagenpapier muß beim Stanzen der Offsetplatten in einem Vollautomaten vor dem Transport in die Stanzsektion betriebszuverlässig entfernt werden. Das bedeutet, daß von einem Plattenstapel nach dem Abnehmen der jeweils obersten Offsetplatte das verbleibende, auf der nächstfolgenden Offsetplatte liegende Papier entfernt werden muß.

Es ist bekannt, dieses Zwischenlagenpapier durch Ausblasen oder Ansaugen zu entfernen. Dies ist jedoch kein betriebszuverlässiges Verfahren, da die verwendeten Zwischenlagenpapiere stark voneinander abweichende Grammgewichte und unterschiedliche Oberflächenrauhigkeiten aufweisen. Auch kommt es bei diesen bekannten Verfahren häufig dazu, daß das Zwischenlagenpapier an der Offsetplatte haften bleibt und den Stanzvorgang beeinträchtigt.

Es ist weiterhin bekannt, das Zwischenlagenpapier mittels eines sog. Vakuumbalkens oder eines -rohrs zu entfernen, aber auch hier treten die bereits erwähnten Probleme auf. Es kommt noch hinzu, daß in einem Stanzautomaten etwa 300 Platten pro Stunde bearbeitet werden können, und dies bedeutet, daß nur ein verhältnismäßig geringer Zeitraum zur Verfügung steht, um die Zwischenlagenpapiere zu entfernen.

Die Erfindung befaßt sich mit dem Problem, eine Vorrichtung der eingangs genannten Art so auszugestalten, daß einerseits ein betriebszuverlässiges Entfernen der Zwischenlagenpapiere gewährleistet ist und andererseits relativ hohe Arbeitsgeschwindigkeiten bei der nachgeschalteten Stanzeinrichtung möglich sind.

Erreicht wird dies durch Vorrichtungen nach den Patentansprüchen.

Im Prinzip werden bei der Vorrichtung gemäß der Erfindung zwei relativ zueinander bewegbare Finger zum Stapel der Offsetplatten gebracht, mindestens ein Finger wird mit dem Zwischenlagenpapier in Berührungslage gebracht, aufgrund der Reibung des Weichgummiteils des Fingers wird ein Teil des Zwischenlagenpapiers zusammengefaltet oder zusammengeschoben und zwischen die beiden Finger gepreßt, so daß durch Herausbewegen des Armes das Zwischenlagenpapier vom Offsetplattenstapel entfernt werden kann.

Als Antrieb für die Relativbewegung der beiden Greifteile kann ein Pneumatikzylinder dienen, dessen Kolbenstange den beweglichen außenliegenden Greifteil zwischen zwei Stellungen bewegen kann.

Der eine Greifteil kann als Rad ausgebildet sein und drehbar auf der Kolbenstange gelagert werden, es kann auch Taumelbewegungen ausführen, so daß durch Verdrehen des Rades erreicht wird, daß die Umfangsfläche der Rundgummidichtung gleichmäßig abgenutzt wird, weil das Rad schrittweise nach jedem Greifvorgang ein Stück weitergedreht wird.

Der innenliegende Greifteil kann prinzipiell in der gleichen Weise wie der äußere Greifteil ausgebildet sein. Er kann jedoch auch die Form einer Viereckscheibe haben, wobei mindestens an einer Kante sich ein Weichgummiteil befindet.

Die beiden Weichgummiteile haben bei einer Ausführungsform der Erfindung im wesentlichen die gleiche Radialerstreckung, die Gummiteile können leicht nachgiebig ausgebildet sein, oder eine solche Form haben, so daß sie in radialer Richtung leicht verformt werden können. Es kommt darauf an, daß einer der Weichgummiteile fast auf das Papier aufgesetzt werden kann, ohne die darunterliegende Oberfläche der Offsetplatte zu beschädigen, wobei der andere Weichgummiteil durch eine Relativbewegung das Zwischenlagenpapier in den Zwischenraum der Greifteile hineinführt und dort erfaßt.

Bei einer anderen Ausführungsform der Vorrichtung gemäß der Erfindung gelangt lediglich der eine Greifteil, vorzugsweise der äußere, in Berührungslage mit dem obersten Zwischenlagenpapier des Stapels der Offsetplatten. Der andere Greifteil verbleibt in einem gewissen geringen Abstand zum obersten Zwischenlagenpapier. Setzt nun der äußere Greifteil auf das Zwischenlagenpapier auf und wird in Richtung auf den anderen Greifteil bewegt, so faltet sich das Papier zwischen den beiden Greifteilen zusammen. Bei dieser Art der Abnahme des Zwischenlagenpapiers wird zuverlässig erreicht, daß das oberste Zwischenlagenpapier gegriffen werden kann.

Die Vorrichtungen gemäß der Erfindung können auch mit einer Lichtschranke versehen werden, die zwischen den beiden Greifteilen wirksam ist. Wird das Papier zwischen den Greifteilen zusammengefaltet, so meldet dies die Lichtschranke. Wird hingegen durch irgendeine Störung kein Zwischenlagenpapier erfaßt, so stellt die Lichtschranke diesen Störungsfall fest und sorgt dafür, daß ein erneuter Greifvorgang durchgeführt wird.

Die Erfindung wird nachstehend anhand der Zeichnung beispielsweise erläutert:

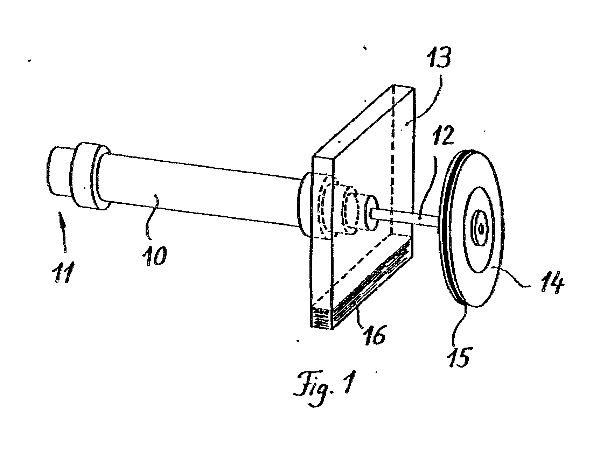

Fig. 1 zeigt eine schaubildliche Ansicht einer Ausführungsform der Vorrichtung gemäß der Erfindung

Fig. 2 zeigt eine vergrößerte Darstellung einiger Teile der in Fig. 1 gezeigten Vorrichtung im Zusammenwirken mit einem Zwischenlagenpapier.

Fig. 3 zeigt eine schaubildliche Ansicht einer weiteren Ausführungsform der Vorrichtung gemäß der Erfindung.

Fig. 4 zeigt eine Seitenansicht der in Fig. 3 gezeigten Vorrichtung gemäß der Erfindung.

Mit 10 ist der Arm der Vorrichtung gemäß der Erfindung gezeigt, dieser ist an einer nicht gezeigten Halterung 11 befestigt, die ermöglicht, daß der Arm auf einen Stapel von Offsetplatten gebracht werden kann, dort in die richtige Höhe gefahren wird und schließlich mit dem eingeklemmten Zwischenlagenpapier aus dem Stapelbereich herausgebracht werden kann.

Im Inneren des Armes 10 befindet sich ein Druckmittelzylinder, auch kann der Arm 10 selbst das Gehäuse eines Druckmittelzylinder darstellen. Eine Kolbenstange 12 des Druckmittelzylinders ist über die Ansteuerung ein- und ausfahrbar. Am äußeren Ende der Kolbenstange ist ein Rad 14 angeordnet, so daß dieses Drehbewegungen mit der Kolbenstange 12 oder relativ zur Kolbenstange 12 ausführen kann.

An der Lauffläche des Rades befindet sich eine Rundgummidichtung 15, diese kann beispielsweise in eine entsprechende Nut unter Vorspannung eingesetzt werden.

Am Gehäuse des Armes 10 ist fest zum Arm 10 eine Viereckscheibe 13 angebracht. An der unteren Begrenzung befindet sich ein Weichteil 16, dessen untere Erstreckung mit der des Rades 14 bzw. der Rundgummidichtung 15 übereinstimmt.

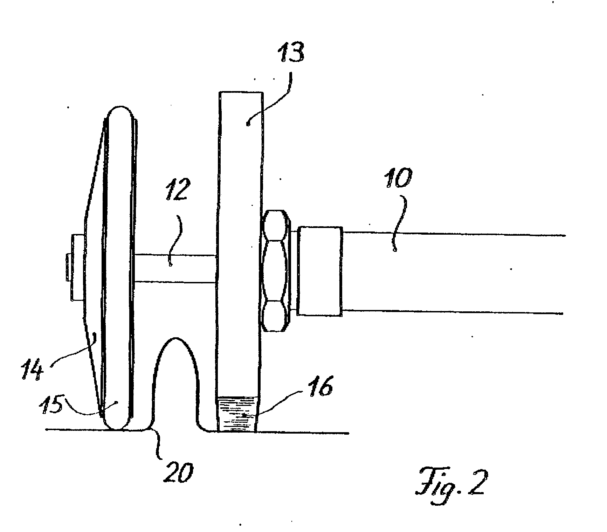

In Fig. 2 ist ein Zeitpunkt gezeigt, wo sich das Rad 14 auf die Scheibe 13 zu bewegt. Da die Dichtung 16 mit einem Zwischenlagenpapier 20 im ortsfesten Eingriff angeordnet ist, nimmt die Rundgummidichtung 15 des Rades 14 das Papier 20 mit, so daß eine Art Welle oder Faltung des Zwischenlagenpapiers 20 entsteht. Es ist ersichtlich, daß bei Aufeinanderlage des Rades 14 an der äußeren Fläche der Scheibe 13 das Papier zwischen diesen Greifteilen 13 und 14 fest eingeklemmt ist. Demzufolge muß das Zwischenlagenpapier 20 die gesteuerte Bewegung des Armes 10 mitmachen, so daß es in einen Abfall- oder Sammelbehälter transportiert werden kann.

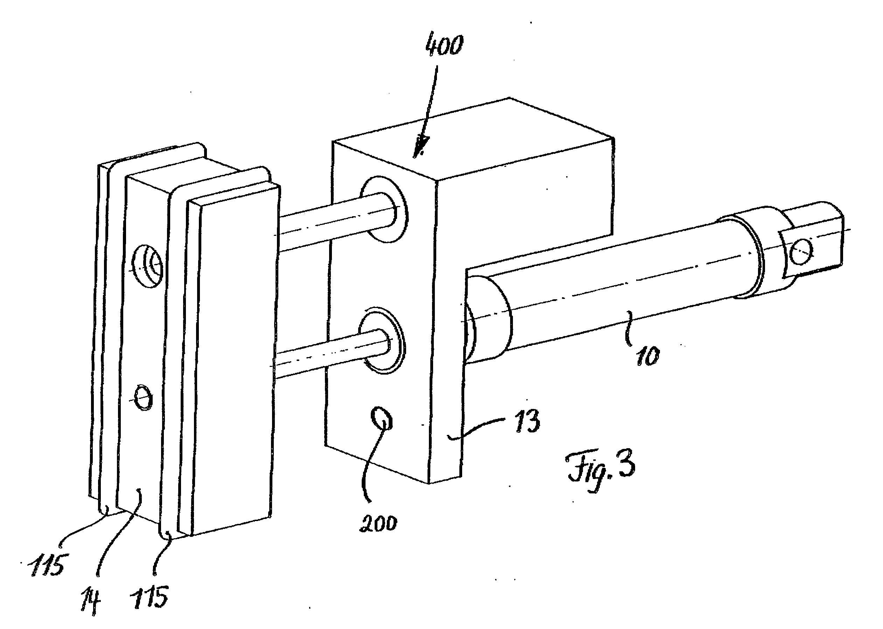

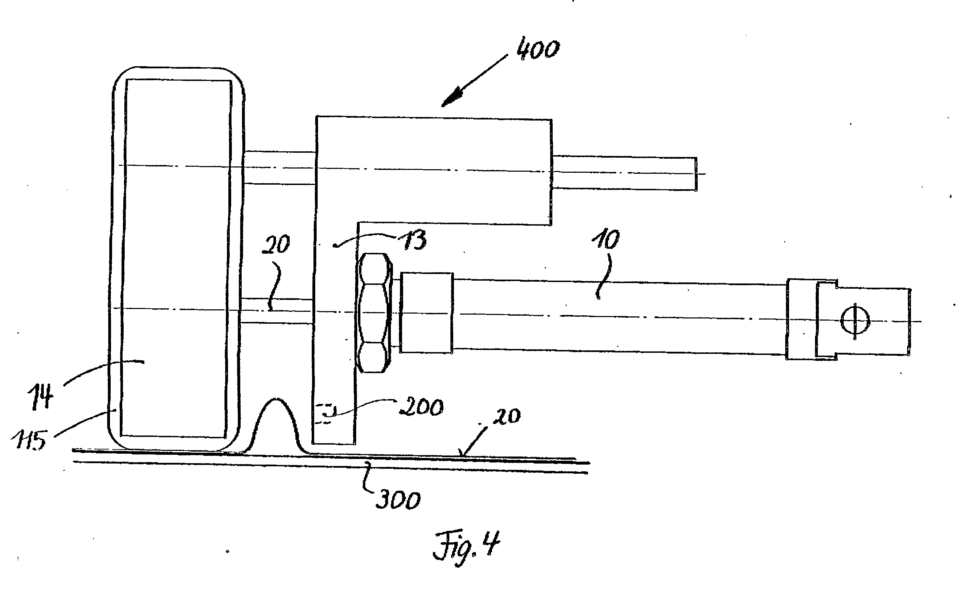

In den Fig. 3 und 4 ist eine alternative Ausführungsform der Erfindung gezeigt. Die mit der ersten Ausführungsform vergleichbaren Teile tragen dieselben Bezugszahlen.

Bei der Ausführungsform nach den Fig. 3 und 4 hat der Greifteil 13 eine geringere Radialerstrek-

kung in Bezug auf die Achse des Armes 10 als der Greifteil 14. Beim Aufsetzen auf einen Stapel Offsetplatten gelangt/gelangen daher nur der oder die Greifteile 115 mit dem Zwischenlagenpapier 20 in Eingriff. In Fig. 4 sind diese Verhältnisse klarer zu erkennen, als in Fig. 3, zusätzlich ist dort auch eine Offsetplatte 300 eingezeichnet.

Der Greifteil 14 zeigt, wie dies wiederum Fig. 3 besser erkennen läßt, zwei Rundgummidichtungen 115, die im Abstand zueinander an einem Greifteil 14 angebracht sind. Die Rundgummiteile 115 sind dabei so geführt worden, daß sie in ihrem unteren Bereich, dem eigentlichen Wirkbereich, eine Erstreckung haben, die zur Achse des Armes 10 parallel ist. Hierdurch wird eine Linienberührung zum Zwischenlagenpapier 20 erreicht, so daß ein sicheres Greifen und Einklemmen zwischen den Teilen 13 und 14 sichergestellt ist.

Im Teil 13 ist mit 200 eine Lichtschrankeneinrichtung gezeigt. Befindet sich zwischen den Greifteilen 13 und 14 beim Aufeinanderzubewegen ein Zwischenlagenpapier 20, so führt dies zu Helligkeitsunterschieden, die die Lichtschranke 200 anzeigt.

In den Fig. 3 und 4 ist mit 400 eine Führungseinrichtung für den Greifteil 14 in Bezug auf den Greifteil 13 bezeichnet. Es handelt sich hierbei um eine übliche Einrichtung zur Führung beweglicher Teile.

**Ansprüche**

1. An einer Stanzeinrichtung bei der Herstellung registerhaltiger Offsetplatten angeordnete Vorrichtung zum Entfernen des obersten Zwischenlagenpapiers der aufeinander gestapelten Offsetplatten, gekennzeichnet durch mindestens einen in den Stapelbereich für die Stanzeinrichtung bringbaren Arm (10), von dessen frei vorstehendem Ende zwei Greifteile (13, 14) im wesentlichen senkrecht nach unten vorstehen, von denen wenigstens einer mit Anpreßteilen (16, 15) an ihren unteren Begrenzungsenden versehen ist, und von denen der eine Greifteil (14) bzw. Anpreßteil (15) zwecks Erfassung des obersten Zwischenlagenpapiers (20) des Stapels auf den anderen Greifteil (13) zu und in einen Klemmeingriff mit diesem bewegbar ist.

2. Vorrichtung nach Anspruch 1, dadurch gekennzeichnet, daß in Arm (10) ein Druckmittelzylinder angeordnet ist, an dessen ausfahrbarer Kolbenstange (12) der äußere Greifteil (14) angebracht ist.

3. Vorrichtung nach Anspruch 2, durch gekennzeichnet, daß der äußere Greifteil (14) als Rad oder Scheibe ausgebildet ist, an dessen Lauffläche bzw. an deren Außenumfangsfläche eine Gummidichtung (15) angebracht ist.

4. Vorrichtung nach Anspruch 3, dadurch gekennzeichnet, daß die Gummidichtung als Rundgummiring (15) ausgebildet ist.

5. Vorrichtung nach einem der Ansprüche 3 bis 4, dadurch gekennzeichnet, daß das Rad (14) auf der Kolbenstange (12) drehbar oder taumelnd gelagert ist.

6. Vorrichtung nach einem der Ansprüche 1 bis 5, dadurch gekennzeichnet, daß der weiter innen liegende Greifteil (16) als Scheibe ausgebildet ist, an der wenigstens im Bereich ihrer unteren Erstreckung ein Gummikissen (16) als Andrückteil angebracht ist.

7. Vorrichtung nach Anspruch 1 oder 2, dadurch gekennzeichnet, daß bei Einsatz nur eines Anpreßteiles (15) dieser einen leicht größeren Abstand zum Arm (10) als der andere Anpreßteil aufweist.

8. Vorrichtung nach Anspruch 7, dadurch gekennzeichnet, daß der Anpreßteil (15) aus mindestens einem, vorzugsweise zwei Gummiringen (115) ausgebildet ist.

9. Vorrichtung nach Anspruch 8, dadurch gekennzeichnet, daß die Gummiringe (115) in ihren Anpressbereichen mit Teilen ausgebildet sind, die sich parallel zum Arm (10) erstrecken.

10. Vorrichtung nach einem der Ansprüche 1 bis 9, dadurch gekennzeichnet, daß zwischen den Greifteilen (13, 14) eine Lichtschranke (200) angebracht ist.

EP 0 328 039 A2

Fig. 1

B 30844/89 - Barensch

Fig. 2

B 30844/89 – Barensc

EP 0 328 039 A2

400

10

13

200

115

14  115

*Fig.3*

B 30844/89 – Barensch

EP 0 328 039 A2

Fig. 4